**Europäisches Patentamt**

**European Patent Office**

**Office européen des brevets**

(11) Numéro de publication: **0 064 905 B1**

(12) **FASCICULE DE BREVET EUROPEEN**

(45) Date de publication du fascicule du brevet:
04.04.84

(21) Numéro de dépôt: **82400733.0**

(22) Date de dépôt: **23.04.82**

(51) Int. Cl.³: **H 01 L 29/80,** H 03 H 11/20 //
G01S7/02

(54) **Dispositif de déphasage variable, à commande électronique, comportant un transistor à effet de champ à grille longue, et circuit d'utilisation d'un tel dispositif.**

(30) Priorité: **30.04.81 FR 8108664**

(43) Date de publication de la demande:
**17.11.82 Bulletin 82/46**

(45) Mention de la délivrance du brevet:
**04.04.84 Bulletin 84/14**

(84) Etats contractants désignés:
**DE GB IT NL**

(56) Documents cités:
**ELECTRONIC LETTERS, vol. 16, no. 14, 3 juillet 1980, pages 553-554, Hitchin Herts (GB); C.TSIRONIS et al.: "Dual gate GaAs M.E.S.F.E.T. phase shifter with gain at 12 GHz".**

(73) Titulaire: **THOMSON-CSF, 173, Boulevard Haussmann, F-75379 Paris Cedex 08 (FR)**

(72) Inventeur: **Diamand, Felix, THOMSON-CSF SCPI 173, bld Haussmann, F-75379 Paris Cedex 08 (FR)**

(74) Mandataire: **Taboureau, James et al, THOMSON-CSF SCPI 173, Bld Haussmann, F-75379 Paris Cedex 08 (FR)**

BUNDESDRUCKEREI BERLIN

## Dispositif de déphasage variable, à commande électronique, comportant un transistor à effet de champ à grille longue et circuit d'utilisation d'un tel dispositif

L'invention concerne un dispositif de déphasage variable d'un signal de faible amplitude en très haute fréquence, comportant un transistor à effet de champ à grille longue, utilisable notamment pour une commande d'antenne à balayage du type électronique.

On connait des déphaseurs de signaux utilisant des transistors à effet de champ à double grille, tels que decrits en pages 553 et 554 de la revue Electronies Letters, vol. 16 n° 14 du 3 juillet 1980.

L'invention permet par l'utilisation d'un transistor à simple grille, d'obtenir un résultat analogue de façon simple et efficace.

Le dispositif selon l'invention est du type comportant un transistor à effet de champ constitué par une couche active d'épaisseur prédéterminée déposée sur un substrat semiconducteur de forte résistivité, sur laquelle sont formés des contacts de source, de grille et de drain. Il est caractérisé en ce que, la longueur de la grille étant déterminée en fonction de l'épaisseur de la couche active, de telle sorte qu'à la fréquence d'utilisation, dans des conditions de polarisation données, on observe un déphasage donné entre un signal de haute fréquence appliqué entre source et grille et le signal de sortie recueilli entre drain et grille, le dispositif comporte en outre des moyens de faire varier au moins la différence de potentiel continu entre source et drain en vue de faire varier le déphasage entre signal d'entrée et de sortie.

L'invention sera mieux comprise, et d'autres caractéristiques, apparaitront, au moyen de la description qui suit, et des dessins qui l'accompagnent, parmi lesquels:

— les figures 1 et 2 représentent schématiquement des exemples de réalisation du dispositif selon l'invention;

— les figures 3 à 7 sont des courbes explicatives;

— les figures 8 et 9 représentent schématiquement un circuit de commande d'antenne utilisant le dispositif selon l'invention.

L'invention est basée sur les remarques suivantes découlant à la fois de la théorie et de l'expérience. Soit un transistor à effet de champ monté en grille commune et dont la longueur de grille (mesurée parallèlement au trajet des porteurs de charge) est de l'ordre de plusieurs fois l'épaisseur de la couche active dans laquelle s'inscrit le canal de conduction. Le matériau semiconducteur peut être soit le silicium, soit l'arséniure de gallium.

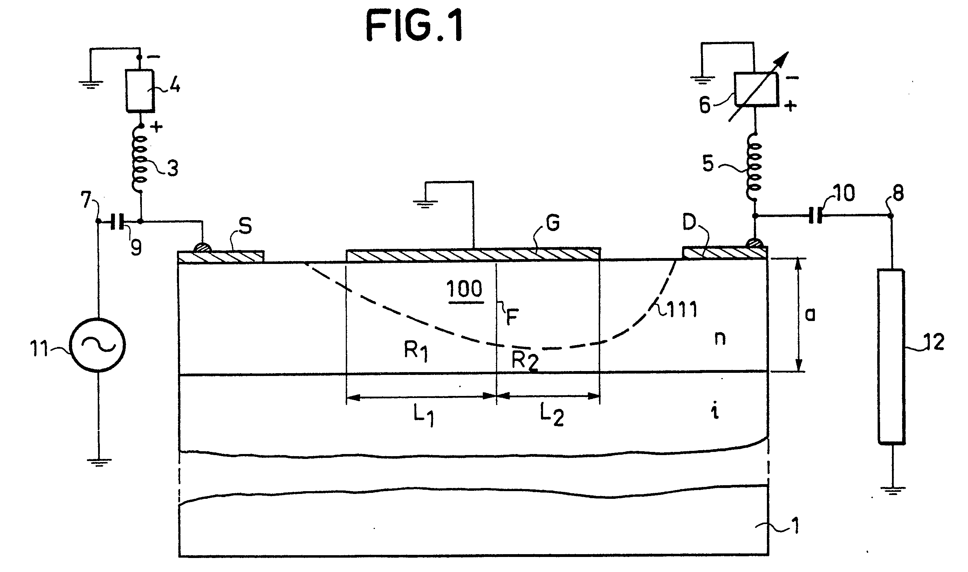

On a représenté à la figure 1, un tel transistor de substrat 1, en arséniure de gallium monocristallin de forte résistivité, supportant une couche épitaxiale dopée N. Son épaisseur a est par exemple de l'ordre du micron. La couche 2 comporte deux contacts ohmiques S et D, destinés à constituer les électrodes de source et de drain. En outre une électrode de grille G est constituée par un contact Schottky dont la longueur mesurée sur le trajet SD est de l'ordre de plusieurs microns.

Dans le dispositif selon l'invention, la grille est par exemple reliée à la masse. La source est reliée à travers une inductance 3 au pôle positif d'une source de polarisation 4 dont le pôle négatif est à la masse. Le drain est relié à travers une inductance 5 au pôle positif d'une source de polarisation 6 de tension variable dont le pôle négatif est à la masse. A titre d'exemple le dispositif comprend:

— une entrée, prise entre la masse et une borne 7 reliée à la source à travers une capacité 9;
— une sortie, prise entre la masse et une borne 8 reliée au drain à travers une capacité 10.

Dans un tel dispositif on observe un déphasage entre un signal d'entrée, d'amplitude faible par rapport à la valeur absolue de la différence de potentiel continue entre grille et source, d'une part, et, d'autre part, le signal de sortie amplifié. Le signal d'entrée est appliqué par exemple à l'aide d'un générateur 11 branché entre masse et borne 7, le signal de sortie étant recueilli sur une charge 12 connectée entre masse et borne 8.

Dans un transistor à effet de champ à canal n, ce qui est le cas, où la différence de potentiel grille-source $V_{GS}$ est négative, soit:

$$V_{GS} = -V_0$$

on sait qu'il se forme sous la grille une zone déserte 100 dont la ligne de démarcation III déborde l'électrode G de part et d'autre. En outre cette ligne III est dissymétrique dès lors qu'il existe entre drain et source une différence de potentiel $V_{DS}$.

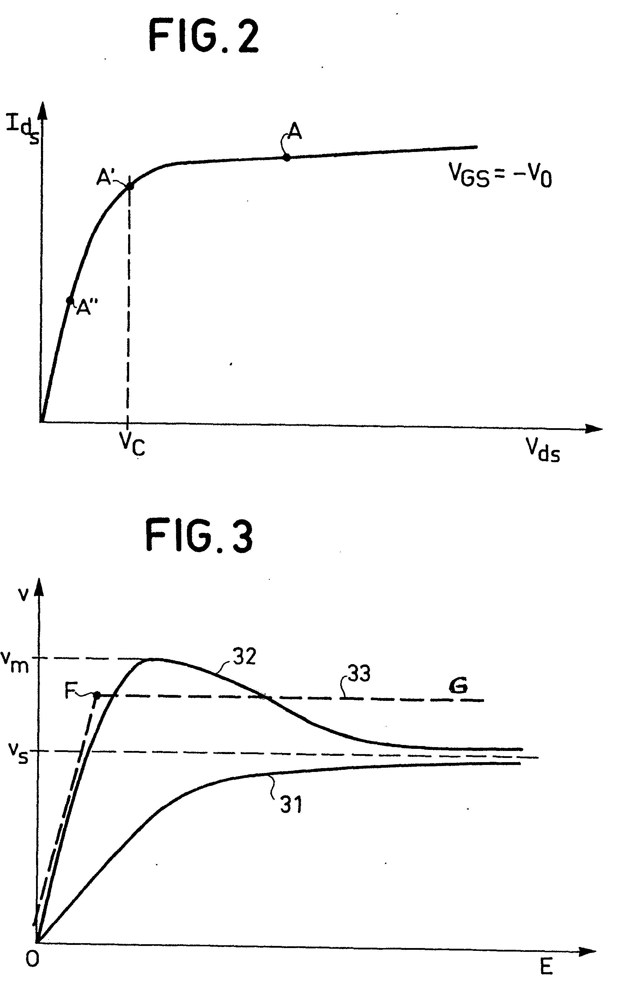

A la figure 2 on a représenté la courbe donnant la variation du courant drain-source $I_{DS}$ en fonction de la différence de potentiel $V_{DS}$, pour une tension $V_{GS}$ égale à $-V_0$.

Lorsque le point de fonctionnement du transistor est en A, c'est à dire nettement localisé au delà du point A' (coude de la caractéristique) la théorie propose, et l'expérience confirme, l'existence de deux régions $R_1$ et $R_2$ divisant la partie du canal de conduction située sous la grille G. Elles sont séparées par une frontière F, correspondant à un point de changement de régime pour les porteurs de charge, ici les électrons. En effet, dans la région $R_1$, la vitesse des électrons s'accroît quand l'électron se rapproche du drain. Dans la région $R_2$, la vitesse cesse de croître ou croît très peu. On se reportera à ce sujet à la figure 3 où l'on a représenté la vitesse v des électrons par rapport à la valeur absolue E du champ électrique dans le cas du silicium (courbe 31) et de l'arséniure de gallium (courbe 32). Les calculs qui sont évoqués ci-après utilisent une approximation dite »par morceaux« correspondant au cas idéal de la courbe 33 où l'on aurait une partie rectiligne OF dans laquelle les électrons se comportent de manière »ohmique«, et une partie FG où la vitesse est parfaitement saturée, soit:

$$v = v_s.$$

Le point fondamental, en ce qui concerne l'invention, réside dans le fait que lorsqu'on fait varier $V_{DS}$ dans certaines limites, la frontière F se déplace dans un sens ou dans l'autre selon le sens même de cette variation. En fait, pour un transistor à canal n, la frontière F se déplace vers la source lorsque $V_{DS}$ augmente, le point représentatif de la figure 2 étant à droite du point A', c'est à dire la tension $V_{DS}$ étant supérieure à la tension de coude $V_C$.

Or dans la région $R_1$ le régime de fonctionnement en très haute fréquence conduit à une forte dissipation d'énergie et par contre le déphasage des signaux varie peu en fonction de l'extension de cette région.

Au contraire, dans la région $R_2$, la dissipation d'énergie est faible et le déphasage sensiblement proportionnel à la longueur de la région $R_2$, soit $L_2$, mesurée parallèlement au trajet des électrons sous la grille.

Il résulte de ce qui précède qu'il est possible de faire varier le déphasage entre petits signaux d'entrée et de sortie en faisant varier la tension entre drain et source $V_{DS}$.

A cet effet on utilisera par exemple un système de commande électronique délivrant sur la borne 8 du dispositif de la figure 1 une tension continue variable en fonction d'un programme préétabli.

On peut prédire l'ordre de grandeur du résultat obtenu en fonction de la tension $V_{DS}$ en se reportant par exemple à une publication de R. A. PUCEL, H. A. HANS et H. S. STATZ dans »Advances in Electronic Physics, Année 1975, N° 8, pages 195–265, Academic Press, New-York« où l'on définit une tension de drain-source normalisée:

$$V_N = \frac{V_{DS}}{V_P}$$

avec $V_P = \dfrac{N\,e\,a^2}{2\,\varepsilon_o\,\varepsilon_r}$

dans laquelle:

N = nombre d'électrons libres par unité de volume;
e = charge de l'électron;
a = épaisseur de la couche active;
$\varepsilon_o = (36\ 10^{-9})^{-1}$
$\varepsilon_r = 12,5$ (constante diélectrique relative de Ga As).

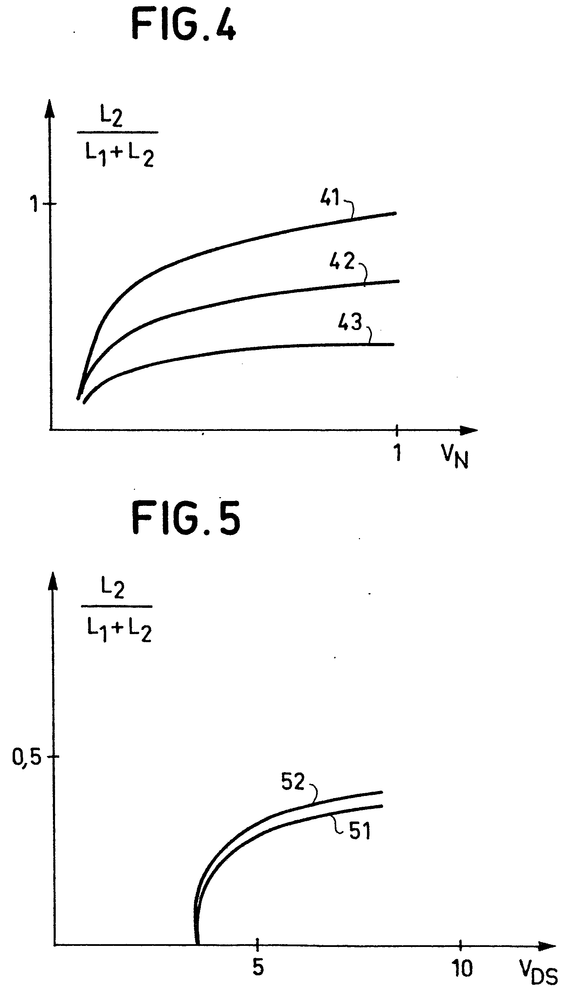

On a représenté à la figure 4 l'un des résultats de l'étude de PUCEL et al. La fonction:

$$\frac{L_2}{L_1 + L_2}$$

est portée en fonction de la tension normalisée $V_N$ dans trois hypothèses:

$L_2/a = 3$ (courbe 41)
$L_2/a = 5$ (courbe 42)
$L_2/a = 10$ (courbe 43).

On observe, sur ces courbes, que $L_2$ est d'autant plus grand par rapport à la longueur de la grille que $V_N$ est plus grand et que le rapport $L_2/a$ est plus petit.

Quant au déphasage, il est proportionnel à la variation de $L_2$ obtenue pour une variation donnée de $V_{DS}$, en utilisant la formule suivante tenant compte de la fréquence F du signal à déphaser et de la vitesse de saturation $v_s$, soit:

$$\Delta\theta = \Delta L_2\ \frac{2\pi F}{v_S}$$

ce qui donne pour F = 10 GHz et $v_S = 1{,}8\ 10^5$ m/s, $\Delta L_2$ exprimé en microns $\Delta\theta = 0{,}35\ \Delta L_2$ (radians)

### Application numérique

A titre d'application numérique on utilise le mode de calcul précité dans le cas d'un transistor à l'arséniure de gallium comportant un canal dopé n à $10^{16}$ cm$^{-3}$, de champ critique 3000 V/cm et de vitesse maximale (assimilée ici à la vitesse de saturation):

$$v_S = 1{,}8\ 10^5\ \text{m/s}.$$

L'épaisseur de la couche active est de deux microns.

La longueur de grille est de 10 microns, la largeur Z étant de 50 microns.

Le potentiel de barrière Schottky est de 0,8 volt.

La tension de pincement $V_P$ est de 29 volts.

Le courant de saturation est donné par la formule:

$$(I_{DS})_S = N\,e\,Z\,a\,v_S$$

avec les mêmes conventions que ci-dessus.

On trouve un courant de saturation de 288 mA.

On a supposé que les résistances ohmiques de source et de drain sont égales à deux ohms.

Les résultats, en bonne concordance avec les courbes générales de la figure 4, sont les suivants:

1. La variation de $L_2$, en valeur relative, est donnée en fonction de la tension drain-source $V_{DS}$ par la figure 5, dans les deux cas suivants:
   $V_o = 0$ (courbe 51)
   $V_o = -2$ V (courbe 52).

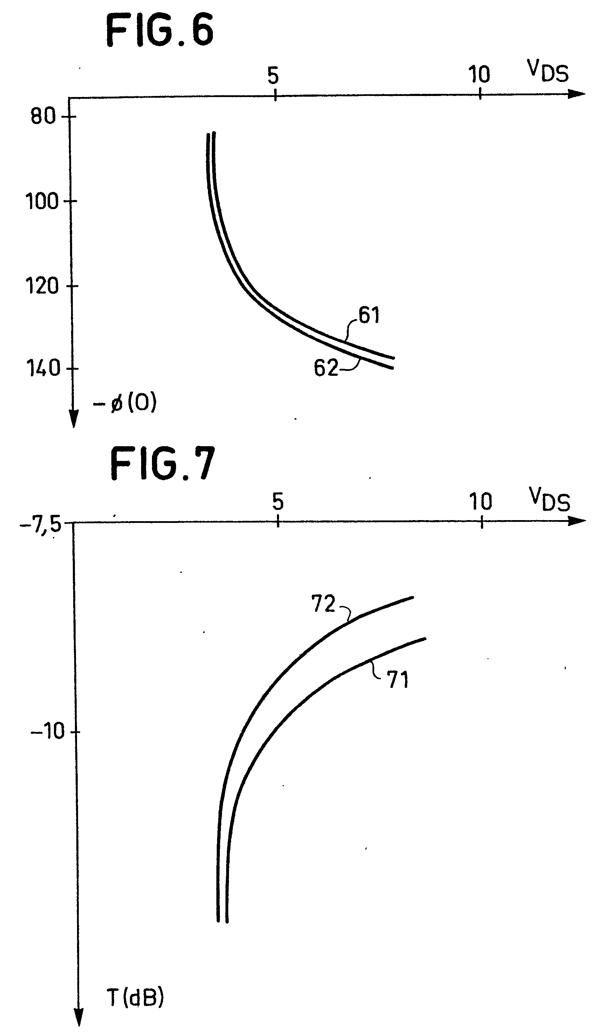

2. Le déphasage (en degrés centigrades), et l'affaiblissement de transmission (en décibels) entre signal de sortie et signal d'entrée sont donnés respectivement aux figures 6 et 7 dans les deux cas déjà mentionnés:
$V_o = 0$ (courbes 61 et 71);
$V_o = -2 V$ (courbes 62 et 72).

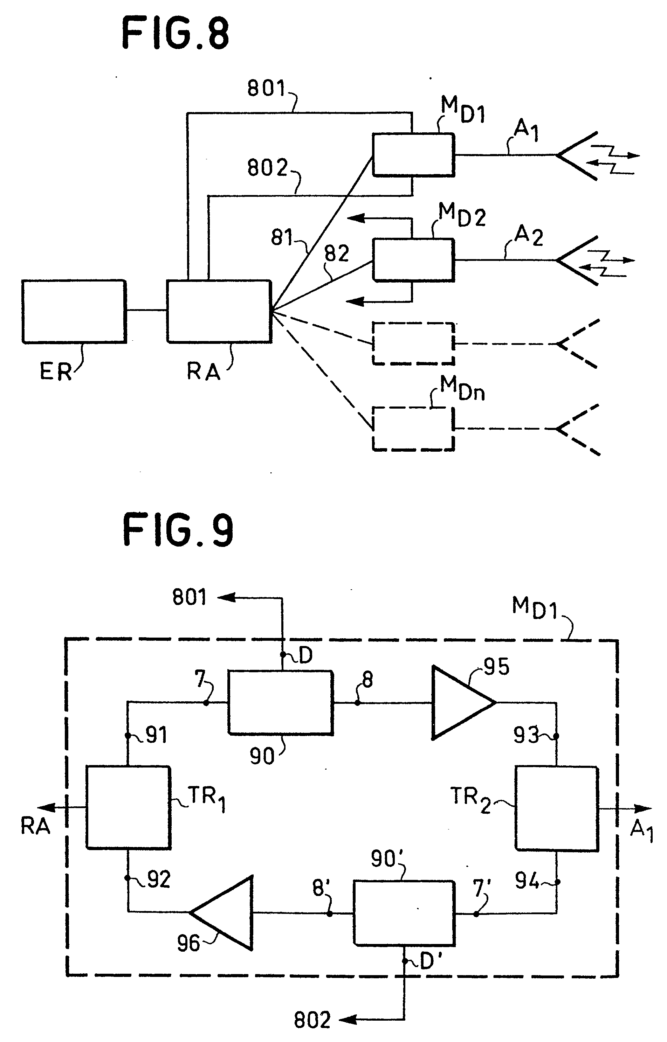

Le dispositif selon l'invention est utilisable dans un système d'émission et de réception d'ondes hertziennes comportant une antenne à balayage électronique. Un tel système est représenté schématiquement aux figures 8 et 9.

Un équipement d'émission et de réception d'ondes électromagnétiques (ER, figure 8) par exemple de signaux radar, émet et reçoit dans l'espace par des éléments d'antenne A1, A2, etc. reliés à un répartiteur de signaux d'antenne RA, et cela par l'entremise de modules de déphasage MD1, MD2...MDn.

Les modules de déphasage sont constitués par des dispositifs semblables à celui de la figure 9. Ils sont reliés au répartiteur RA par des connexions 81, 82, etc. transmettant les signaux d'émission ou de réception. En outre le répartiteur RA comporte des équipements (non représentés) de commande électronique transmettant à des instants prédéterminés des tensions continues de commande aux modules MD1, MD2, etc. par des lignes de commande automatique 801, 802, etc.

On a représenté schématiquement, à la figure 9, un module de déphasage MD1. Il comporte deux dispositifs classiques d'aiguillage (dits commutateurs »TR« en technique radar) TR1 et TR2. Dans le schéma de la figure 9, les liaisons bifilaires sont représentées par un simple trait. Entre les dispositifs TR1 et TR2 existent une voie d'émission (entre les bornes 91 et 93 de ces dispositifs) et une voie de réception (entre les bornes 92 et 94 des mêmes dispositifs). Sur la voie d'émission on trouve un dispositif selon l'invention 90, semblable à celui de la figure 1, intercalé par ses bornes 7 et 8 dans la voie d'émission (la masse n'étant pas visible en raison du mode de représentation adopté). De même, sur la voie réception on trouve un dispositif analogue 90' intercalé par ses bornes 7' et 8'. Chaque voie comporte en outre un amplificateur 95 ou 96.

En outre, les drains des transistors (non représentés) des dispositifs 90 et 90' sont connectés aux lignes 801 et 802 de commande automatique.

Le fonctionnement du système est le suivant:

A l'émission, les signaux empruntant la voie 91−93, grâce aux commutateurs TR1 et TR2, subissent en traversant le transistor du dispositif 90 un déphasage dont la valeur est imposée par la tension de commande reçue par la ligne 801. Les signaux sont ensuite amplifiés par un amplificateur 95 intercalé sur la voie émission, enfin rayonnés dans l'espace par l'élément d'antenne A1.

A la réception, les signaux empruntant la voie 94−92, grâce aux commutateurs TR1 et TR2, subissent en traversant le transistor du dispositif 90' un déphasage dont la valeur est imposée par la tension de commande reçue par la ligne 802. Les signaux sont ensuite amplifiés par un amplificateur 96 intercalé sur la voie de réception et enfin reçus dans les équipements de réception par l'intermédiaire du répartiteur RA.

Dans une variante non représentée, on intercale deux ou plusieurs dispositifs en série (90, 90') selon l'invention dans chacune des voies d'émission et réception du module de déphasage, de telle sorte que le déphasage total soit la somme des déphasages apportés par les différents transistors des dispositifs 90 et 90'.

## Revendications

1. Dispositif de déphasage variable à commande électronique du type comportant un transistor à effet de champ constitué par une couche active d'épaisseur prédéterminée déposée sur un substrat semiconducteur de forte résistivité, sur laquelle sont formés des contacts de source, de grille et de drain, caractérisé en ce que la longueur de la grille est déterminée en fonction de l'épaisseur de la couche active, de telle sorte qu'à la fréquence d'utilisation, dans des conditions de polarisation données, on observe un déphasage donné entre un signal de haute fréquence appliqué entre source et grille et le signal de sortie recueilli entre drain et grille, le dispositif comportant en outre des moyens de faire varier au moins la différence de potentiel continue entre source et drain en vue de faire varier le déphasage entre le signal d'entrée et le signal de sortie.

2. Dispositif selon la revendication 1, caractérisé en ce que le rapport entre la longueur de grille du transistor à effet de champ et l'épaisseur de la couche active est au moins égale à deux.

3. Dispositif selon la revendication 1, caractérisé en ce que lesdits moyens sont constitués par une source variable de polarisation continue appliquée entre drain et grille, la polarisation de la grille par rapport à la source étant fixe.

4. Dispositif selon la revendication 1, caractérisé en ce qu'il comporte un transistor à l'arséniure de gallium.

5. Circuit d'utilisation d'un dispositif selon l'une quelconque des revendications 1 à 4, caractérisé en ce qu'il comporte des modules de déphasage constitués par deux commutateurs d'émission et de réception reliés par une voie d'émission et une voie de réception, chacune de ces voies comprenant en série un amplificateur et un dispositif de déphasage variable à commande électronique.

## Patentansprüche

1. Vorrichtung zur elektronisch gesteuerten variablen Phasenverschiebung, von der Art mit einem Feldeffekttransistor, der durch eine auf einem Halbleitersubstrat mit großem elektrischen Widerstand aufgebrachte aktive Schicht vorbestimmter Dicke gebildet ist, auf der die Source-, Gate- und Drain-Kontakte gebildet sind, dadurch gekennzeichnet, daß die Länge des Gates in Abhängigkeit von der Dicke der aktiven Schicht derart bestimmt ist, daß bei der Anwendungsfrequenz unter den gegebenen Polarisationsbedingungen eine gegebene Phasenverschiebung zwischen einem zwischen Source und Gate angelegten Hochfrequenzsignal und dem zwischen Drain und Gate abgenommenen Ausgangssignal beobachtet wird, wobei die Vorrichtung ferner Mittel umfaßt, um wenigstens die Gleichpotentialdifferenz zwischen Source und Drain zu verändern und so die Phasenverschiebung zwischen dem Eingangssignal und dem Ausgangssignal zu verändern.

2. Vorrichtung nach Anspruch 1, dadurch gekennzeichnet, daß das Verhältnis zwischen der Gatelänge des Feldeffekttransistors und der Dicke der aktiven Schicht wenigstens gleich zwei ist.

3. Vorrichtung nach Anspruch 1, dadurch gekennzeichnet, daß die genannten Mittel gebildet sind aus einer Quelle für eine variable Gleichpolarisierung, die zwischen Drain und Gate angelegt wird, wobei die Polarisierung des Gates in bezug auf die Source-Elektrode gleichbleibend ist.

4. Vorrichtung nach Anspruch 1, dadurch gekennzeichnet, daß sie einen Galliumarsenid-Transistor enthält.

5. Schaltkreis zur Anwendung einer Vorrichtung nach einem der Ansprüche 1 bis 4, dadurch gekennzeichnet, daß sie Phasenschiebermoduln umfaßt, die aus zwei Sende- und Empfangs-Schaltern gebildet sind, welche durch einen Sendekanal und einen Empfangskanal verbunden sind, wobei jeder dieser Kanäle einen Verstärker in Reihe mit einer Vorrichtung für elektronisch gesteuerte variable Phasenverschiebung umfaßt.

## Claims

1. Device for electronically controlled variable phase shifting of the type comprising a field-effect transistor formed by an active layer of predetermined thickness applied to a semiconductor substrate of high electrical resistance on which the source, gate and drain contacts are formed, characterized in that the length of the gate is determined in dependence on the thickness of the active layer in such a manner that at the use frequency under given polarization conditions a given phase shifting is observed between a highfrequency applied between source and gate and the output signal taken from between drain and gate, the device further comprising a means for varying at least the direct potential difference between source and drain in order to vary the phase shift between the input signal and the output signal.

2. Device according to claim 1, characterized in that the ratio between the length of the gate of the field-effect transistor and the thickness of the active layer is at least equal to two.

3. Device according to claim 1, characterized in that said means are formed by a variable direct polarization source applied between drain and gate, the polarization of the gate with respect to the source being fixed.

4. Device according to claim 1, characterized in that it comprises a gallium arsenide transistor.

5. Circuit for using a device according to any one of claims 1 to 4, characterized in that it comprises phaseshifting modules formed by two transmission and reception switches connected by a transmission channel and a reception channel, each of said channels comprising in series an amplifier and a device for electronically controlled variable phase shifting.

# FIG.1

0 064 905

# FIG.2

# FIG.3

# FIG.4

# FIG.5

# FIG.6

# FIG.7

# FIG.8

801

$M_{D1}$

$A_1$

802

81  82

$M_{D2}$

$A_2$

$M_{Dn}$

ER

RA

# FIG.9

801

D

7

90

8

95

$M_{D1}$

91

93

RA

$TR_1$

$TR_2$

$A_1$

92

96

8'

90'

7'

94

D'

802

15